(19) Europäisches Patentamt

European Patent Office

Office européen des brevets

(11) **EP 1 589 657 A1**

(12) **DEMANDE DE BREVET EUROPEEN**

(43) Date de publication:
26.10.2005 Bulletin 2005/43

(51) Int Cl.7: **H03F 1/30**, H03F 1/22, H03F 3/45

(21) Numéro de dépôt: 04101609.8

(22) Date de dépôt: **19.04.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL LT LV MK**

(71) Demandeur: **CSEM**
**Centre Suisse d'Electronique et de Microtechnique SA**
**2007 Neuchâtel (CH)**

(72) Inventeur: **Melly, Thierry**
**1015, Lausanne (CH)**

(74) Mandataire: **Vigand, Philippe et al**
**ICB,**
**Ingénieurs Conseils en Brevets SA,**
**Rue des Sors 7**
**2074 Marin (CH)**

(54) **Circuit d'asservissement de la transconductance d'au moins un transistor en conduction**

(57) Le circuit (1) d'asservissement permet d'asservir la transconductance d'au moins un transistor (N1) en conduction. Pour ce faire, le circuit comprend un bloc transconducteur (2) qui comprend le transistor en conduction, un bloc de polarisation (3) pour polariser le bloc transconducteur, et un bloc de charge ($R_L$) recevant un courant de charge fourni par le bloc transconducteur. Le bloc de polarisation comprend une résistance de référence ($R_0$), pour que le bloc de polarisation fournisse au bloc transconducteur au moins un signal de polarisation qui dépend de la résistance de référence pour ajuster la tension entre deux bornes de courant du transistor en conduction. De cette manière, la valeur de la transconductance du transistor en conduction (N1) est inversement proportionnelle à la valeur de la résistance de référence ($R_0$).

Fig. 1

**Description**

L'invention concerne un circuit d'asservissement de la transconductance d'au moins un transistor en conduction. Le circuit d'asservissement comprend un bloc transconducteur qui comprend le transistor en conduction, un bloc de polarisation pour polariser le bloc transconducteur et un bloc de charge recevant un courant de charge fourni par le bloc transconducteur.

L'utilisation de transistors en conduction, par exemple de type MOS, pour la réalisation de blocs transconducteurs est bien connue dans l'état de la technique. Ces blocs transconducteurs peuvent être utilisés dans plusieurs applications techniques, telles que, par exemple, dans des filtres à courant continu ou dans des mélangeurs pour des étages de conversion de fréquence de signaux de données.

Habituellement, la transconductance d'un transistor en conduction est variable en fonction notamment de la différence de tension entre le drain et la source du transistor MOS en conduction. Cependant, il peut être souhaité selon certaines conditions exigées par l'application technique dans laquelle le transistor en conduction est utilisé, d'assurer un asservissement de sa transconductance en fonction d'un paramètre déterminé. Par cet asservissement de la transconductance du transistor en conduction, il peut, par exemple, être assuré un courant de charge déterminé pour le bloc de charge connecté au bloc transconducteur.

Un but de l'invention est de fournir un circuit d'asservissement de la transconductance d'au moins un transistor en conduction de manière que la transconductance soit asservie par un paramètre particulier du circuit pour permettre, notamment, d'assurer un gain fixe en tension dudit transistor en conduction.

A cet effet, l'objet de l'invention concerne un circuit d'asservissement de la transconductance d'au moins un transistor en conduction qui comprend les caractéristiques mentionnées dans la revendication 1.

Des formes d'exécution avantageuses du circuit sont définies dans les revendications dépendantes 2 à 8.

Un avantage du circuit selon l'invention réside dans le fait qu'une résistance de référence, placée dans le bloc de polarisation, permet de fournir un signal de polarisation au bloc transconducteur de manière que la tension entre les deux bornes de courant du transistor en conduction soit ajustée. Ces deux bornes de courant sont, par exemple, la borne de source et la borne de drain d'un transistor MOS. De cette façon, la valeur de la transconductance devient inversement proportionnelle à la valeur de la résistance de référence.

Dans le cas où le courant du transistor en conduction est utilisé comme courant de charge d'un bloc de charge, qui comprend au moins une résistance de charge, l'asservissement de la transconductance à l'aide de la résistance de référence permet d'obtenir un gain en tension déterminé et dépendant d'un rapport de résistances. Ce gain en tension n'est ainsi pas influencé par la dispersion de la valeur absolue de chacune des résistances ni par la variation en température pouvant affecter la valeur de ces dernières, ce qui est un avantage supplémentaire. Comme le circuit d'asservissement peut être réalisé dans une technologie CMOS, il est important de s'affranchir de toute dispersion de valeur des résistances de manière à obtenir un gain en tension indépendant de la variation des valeurs des résistances.

Les buts, avantages et caractéristiques du circuit d'asservissement de la transconductance d'au moins un transistor en conduction apparaîtront mieux dans la description suivante de formes d'exécution illustrées par les dessins sur lesquels :

- la figure 1 représente une forme d'exécution d'un circuit d'asservissement de la transconductance d'un transistor en conduction selon l'invention,
- la figure 2 représente un amplificateur réalisé à l'aide d'un circuit d'asservissement de la transconductance de transistors en conduction selon l'invention, et
- la figure 3 représente un mélangeur pour la conversion de fréquence de signaux réalisé à l'aide du circuit d'asservissement de la transconductance de transistors en conduction selon l'invention.

Dans la description suivante, tous les éléments ou les fonctions du circuit d'asservissement qui sont bien connus de l'homme du métier dans ce domaine technique ne seront décrits que de manière simplifiée, notamment en ce qui concerne les dimensions de chaque transistor. De préférence, le circuit d'asservissement est réalisé dans une technologie CMOS par exemple à 0,18 μm avec des transistors d'un premier type de conductivité N (NMOS) et d'un second type de conductivité P (PMOS).

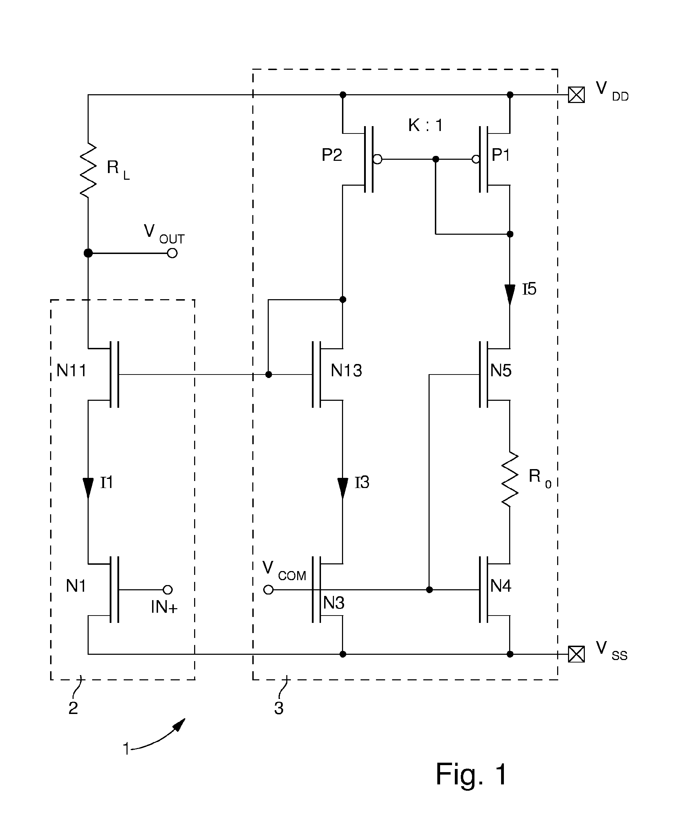

La figure 1 montre un circuit d'asservissement 1 de la transconductance d'au moins un transistor en conduction selon l'invention dans une forme simple de réalisation. Ce circuit d'asservissement 1 comprend un bloc transconducteur 2, qui comprend notamment le transistor en conduction de préférence de type NMOS N1, un bloc de polarisation 3 pour polariser le bloc transconducteur, et un bloc de charge représenté par une résistance de charge $R_L$. Le circuit d'asservissement 1 est connecté par une première borne d'alimentation $V_{SS}$ et une seconde borne d'alimentation $V_{DD}$ à une source de tension continue d'alimentation non représentée. Pour le fonctionnement du circuit d'asservissement 1, la tension d'alimentation peut être comprise entre 0,9 et 1,8 V.

Le bloc transconducteur 2 est constitué, dans cette forme d'exécution, du transistor en conduction N1 pour lequel la transconductance doit être ajustée, et d'un transistor de commande NMOS N11 monté en série dans un montage cascode avec le transistor N1. Ce transistor de commande N11 a pour but d'ajuster la tension entre les bornes de courant du transistor en conduction N1.

Pour ce faire, la borne de source du transistor en conduction N1 est reliée à la première borne d'alimentation $V_{SS}$ qui peut être une borne de masse, et la borne de drain du transistor N1 est reliée à la borne de source du transistor de commande N11. La borne de commande, c'est-à-dire la borne de grille IN+ du transistor en conduction N1 est destinée à recevoir une tension alternative $V_{IN+}$ centrée autour d'une tension en mode commun $V_{COM}$. Cette tension en mode commun est définie au-dessus de la tension de seuil du transistor pour le placer, de préférence, dans un mode en forte inversion.

La borne de grille du transistor de commande N11 est reliée à la borne de grille d'un transistor intermédiaire NMOS N13 du bloc de polarisation 3, qui a pour but de transmettre un signal de polarisation au bloc transconducteur 2. La borne de grille du transistor intermédiaire N13 est reliée directement à sa borne de drain pour transmettre le signal de polarisation sous forme d'une tension continue de grille au transistor de commande N11. Comme on le comprendra dans la description ci-après, le niveau de cette tension de grille est défini grâce à une résistance de référence $R_0$ du bloc de polarisation.

En fixant la tension de grille du transistor de commande N11, la tension entre le drain et la source du transistor en conduction N1, définie comme une tension de drain $V_{D1}$, est ajustée en fonction de la résistance de référence $R_0$ du bloc de polarisation 3 selon l'invention. La valeur de la transconductance gm du transistor en conduction N1 est, en effet, inversement proportionnelle à la valeur de la résistance de référence $R_0$.

Le courant délivré par le transistor en conduction traverse le transistor de commande N11. Ce courant va servir de courant de charge pour la résistance de charge $R_L$ qui est reliée entre la seconde borne d'alimentation $V_{DD}$ et la borne de drain du transistor de commande N11.

Si, comme mentionné précédemment, la transconductance gm est inversement proportionnelle à la résistance $R_0$ du bloc de polarisation 3, le gain en tension du transistor N1, qui est égal au rapport $V_{OUT}/V_{IN+}$, est proportionnel à gm fois $R_L$ et, donc, au rapport de la résistance de charge $R_L$ à la résistance de référence $R_0$. De ce fait, avec ce rapport de résistances, un gain en tension peut être asservi tout en procurant l'avantage d'être indépendant des valeurs absolues des résistances $R_L$ et $R_0$, qui peuvent varier d'environ 30% dans une technologie CMOS. De plus, cet agencement permet de s'affranchir des variations de température pouvant affecter chacune des résistances, puisque seul leur rapport est pris en compte.

Le bloc de polarisation 3, dans lequel la résistance de référence $R_0$ est placée, comprend tout d'abord un premier miroir de courant qui est composé de deux transistors PMOS P1 et P2, dont la borne de source des transistors est reliée à la seconde borne d'alimentation $V_{DD}$ du circuit. Le premier transistor PMOS P1 est monté en diode avec la borne de grille reliée à la borne de drain, et le second transistor PMOS P2 a sa borne de grille reliée à la borne de grille du premier transistor PMOS. Le rapport largeur de canal W sur longueur de canal L de chaque transistor P1 et P2 est choisi de manière que le courant dans le second transistor P2 soit k fois plus fort que le courant dans le premier transistor P1 du premier miroir de courant. Ce facteur k est de préférence un nombre entier supérieur à 1, par exemple égal à 2.

Le bloc de polarisation 3 comprend encore deux transistors NMOS N3 et N4, dont la borne de source de ces transistors est reliée à la première borne d'alimentation $V_{SS}$ du circuit, ainsi qu'un transistor suiveur NMOS N5. La borne de grille du premier transistor NMOS N3 est reliée à la borne de grille du second transistor NMOS N4 afin d'être polarisée par une tension continue en mode commun $V_{COM}$, qui est au-dessus des tensions de seuil de ces transistors NMOS. Ces transistors NMOS N3 et N4 fonctionnent, de préférence, en forte inversion mais peuvent, également, être polarisés pour fonctionner en faible inversion.

Le transistor suiveur NMOS N5 a sa borne de grille reliée à la borne de grille des premier et second transistors NMOS N3 et N4, et sa borne de drain reliée à la borne de drain du premier transistor PMOS P1. La résistance de référence $R_0$ est connectée entre la borne de source du transistor NMOS N5 et la borne de drain du second transistor NMOS N4 dans une branche de référence. Le transistor N5 a la particularité d'être polarisé de manière à constituer un suiveur de tension, c'est-à-dire avec un décalage d'une tension de seuil $V_{TN}$.

Le second transistor PMOS P2 a sa borne de drain reliée à la borne de drain du transistor intermédiaire NMOS N13 monté en diode. La borne de source de ce transistor intermédiaire est, quant à elle, reliée à la borne de drain du premier transistor NMOS N3 dans une branche de courant miroité.

Pour comprendre la relation entre la transconductance gm du transistor en conduction N1 et la résistance $R_0$ du bloc de polarisation, des formules des courants dans le transistor N1 et dans les transistors N3 et N5 sont données ci-dessous :

$$I1 = n \cdot \beta_1 \cdot ((V_{COM} + V_{IN+}(t) - V_{TN})/n - V_{D1}/2) \cdot V_{D1}$$

avec

$$\beta_1 = \mu \cdot C_{ox} \cdot W_1/L_1$$

$$gm1 = d(I1)/d(V_{IN+}) = \beta_1 \cdot V_{D1}$$

$$I3 = n \cdot \beta_3 \cdot ((V_{COM} - V_{TN})/n - V_{D3}/2) \cdot V_{D3}$$

avec

$$\beta_3 = \mu \cdot C_{ox} \cdot W_3/L_3$$

$$I3 = k \cdot I5 \tilde{} \; k \cdot (V_{COM} - V_{TN} - V_{D4})/R_0$$

avec

$$V_{D4} = n \cdot V_{D3}/2$$

où $V_{D1}$ et $V_{D3}$ sont les tensions de drain des transistors N1 et N3, $V_{TN}$ est la tension de seuil, $V_{COM}$ et $V_{IN+}(t)$ sont respectivement la tension en mode commun et la tension alternative autour de $V_{COM}$ sur la borne IN+. Le facteur de pente n, la mobilité $\mu$, la capacité $C_{ox}$, la largeur de canal W et la longueur de canal L sont des paramètres des transistors ou de la technologie CMOS utilisée.

La transconductance gm du transistor NMOS N1 est égale à $\beta_1 \cdot V_{D1}$, ce qui fait qu'en maintenant la tension de drain $V_{D1}$ à une valeur déterminée par la polarisation du transistor de commande N11 grâce à la résistance de référence $R_0$, cette transconductance gm est dépendante de la résistance $R_0$. Pour une tension $V_{IN+}$ égale à 0, on arrive à déduire, par les formules données ci-dessus, que la tension de drain $V_{D1}$ du transistor N1 est égale à la tension de drain $V_{D3}$ du transistor N3. De ce fait, la tension de drain $V_{D1}$ du transistor N1 est égale à $k/(R_0 \cdot \beta_3)$, ce qui a pour conséquence que la transconductance gm est égale à $k \cdot \beta_1/R_0 \cdot \beta_3$. Ceci prouve que la valeur de la transconductance gm est bien inversement proportionnelle à la valeur de la résistance de référence $R_0$.

Pour donner un ordre de grandeur des valeurs des courants et des résistances d'un tel circuit d'asservissement, le courant I1 peut valoir 100 µA à $V_{IN+} = 0$, alors que le courant I3 peut valoir 10 µA et le courant I5 peut valoir 5 µA en adaptant le rapport de largeur sur longueur de canal des transistors. La résistance de référence $R_0$ est égale par exemple à 50 kO, alors que la résistance de charge $R_L$ est égale à 5 kO en étant réalisée de manière identique à la résistance de référence. La tension en mode commun $V_{COM}$ peut être située entre 50 à 300 mV au-dessus de la tension de seuil $V_{TN}$.

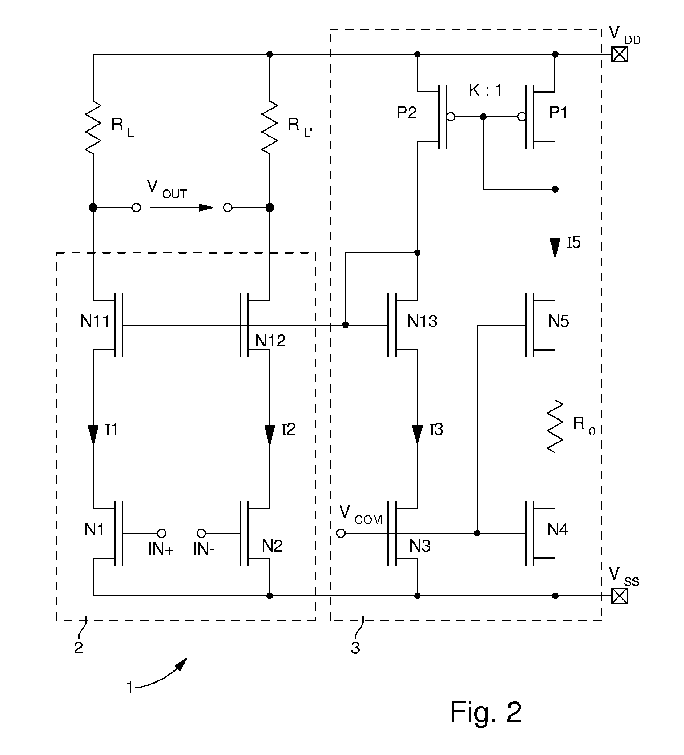

La figure 2 montre un amplificateur qui est réalisé à l'aide du circuit d'asservissement de la transconductance de transistors en conduction 1. Il est à noter que tous les mêmes éléments du circuit qui ont été décrits dans la figure 1 portent des signes de référence identiques. De ce fait par simplification, il ne sera pas répété la description de ces éléments.

Une des différences du circuit d'asservissement présenté à la figure 2 est que le bloc transconducteur 2 comprend deux transistors NMOS en conduction N1 et N2 reliés respectivement à deux transistors NMOS de commande N11 et N12 dans un montage en cascode. La borne de source des deux transistors en conduction N1 et N2 est reliée à la première borne d'alimentation $V_{SS}$ du circuit, et la borne de grille des deux transistors de commande N11 et N12 est reliée à la borne de grille du transistor intermédiaire NMOS N13 du bloc de polarisation 3. De cette façon, la tension entre la source et le drain de chaque transistor en conduction N1 et N2 est ajustée par une tension de grille appliquée sur la borne de grille des transistors de commande NMOS N11 et N12 grâce à la résistance de référence $R_0$. La valeur de la transconductance gm de chaque transistor en conduction N1 et N2 est donc inversement proportionnelle à la valeur de la résistance de référence $R_0$ comme décrit précédemment.

Une résistance de charge supplémentaire $R_{L'}$ est ajoutée dans le bloc de charge entre la seconde borne d'alimentation $V_{DD}$ et la borne de drain du transistor de commande N12. Le courant de charge I2 de valeur moyenne équivalente à I1 déterminé par le transistor N2 traverse le transistor de commande N12, ainsi que la résistance de charge $R_{L'}$. La tension de sortie $V_{OUT}$ de l'amplificateur est fournie à la connexion de chaque résistance de charge $R_L$ et $R_{L'}$, et de la borne de drain de chaque transistor de commande N11 et N12.

Dans cette forme d'exécution relative à un amplificateur, la tension alternative $V_{IN-}$ autour de la tension en mode commun $V_{COM}$ appliquée à la borne IN- du transistor en conduction N2 est l'inverse de la tension alternative $V_{IN+}$ autour de la tension en mode commun $V_{COM}$ appliquée à la borne IN+ du transistor en conduction N1. De ce fait dans cette version différentielle, la tension de charge de chaque résistance $R_L$ et $R_{L'}$ est également de polarité inversée par rapport à une tension moyenne lorsque $V_{IN+}$ et $V_{IN-}$ valent 0.

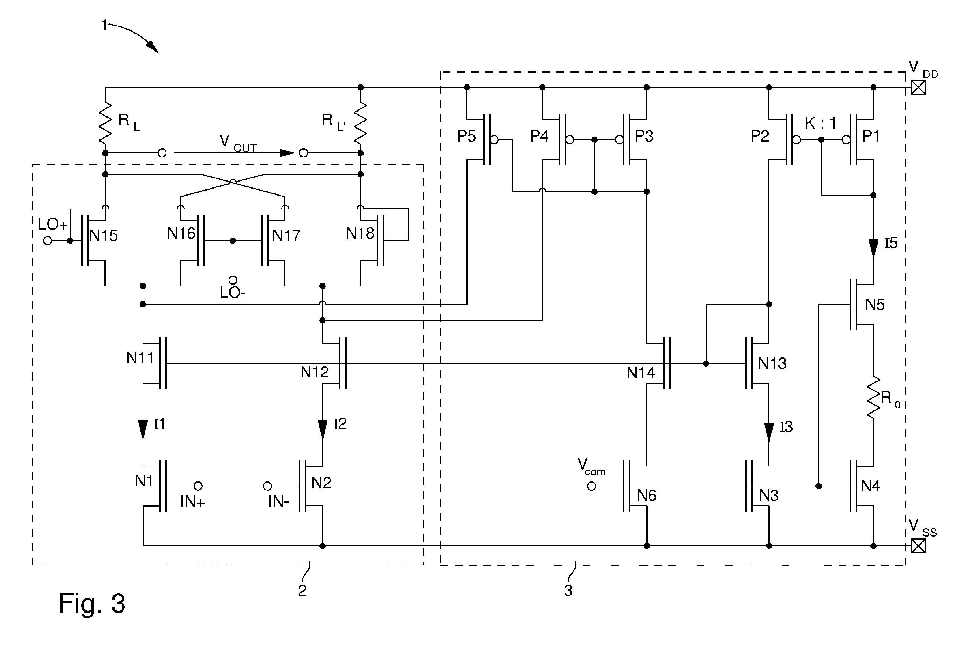

La figure 3 montre finalement un mélangeur pour la conversion de fréquence de signaux réalisé à l'aide du circuit d'asservissement de la transconductance de transistors en conduction. Comme précédemment, tous les mêmes éléments du circuit qui ont été décrits dans les figures 1 et 2 portent des signes de référence identiques. De ce fait par simplification, il ne sera pas répété la description de ces éléments.

Dans cette forme d'exécution sous forme d'un mélangeur, le bloc transconducteur 2 comprend encore deux paires différentielles de transistors NMOS N15, N16, N17 et N18 placées entre les résistances de charge $R_L$ et $R_{L'}$ et la borne de drain des transistors de commande N11 et N12. La borne de source des transistors NMOS de la première paire N15 et N16 est reliée à la borne de drain du premier transistor de commande N11 et la borne de source des transistors NMOS de la seconde paire N17 et N18 est reliée à la borne de drain du second transistor de commande N12.

La résistance de charge $R_L$ est connectée entre la seconde borne d'alimentation $V_{DD}$ du circuit et la borne de drain du premier transistor N15 de la première paire et du second transistor N17 de la seconde paire. La résistance de charge $R_{L'}$ est, quant à elle, connectée entre la seconde borne d'alimentation du circuit et la borne de drain du second transistor N16 de la première paire et du premier transistor N18 de la seconde paire. La borne de grille LO+ des premiers transistors N15 et N18 des première et seconde paires est commandée par une première tension alternative d'une première source de tension, alors que la borne de grille LO- des seconds transistors N16 et N17 des première et seconde paires est commandée par une seconde tension alternative d'une seconde source de tension. La première tension alternative est de forme identique à la seconde tension alternative mais déphasée de 180°.

Les courants I1 et I2 sont des courants alternatifs dus à la variation des tensions $V_{IN+}$ et $V_{IN-}$ appliquées respectivement aux bornes IN+ et IN- des transistors en conduction N1 et N2. Les tensions alternatives $V_{IN+}$ et $V_{IN-}$ autour de la tension en mode commun $V_{COM}$ sont de forme identique, mais déphasées de 180° l'une de l'autre. Pour un mélangeur de signaux pour la conversion de fréquence, les tensions $V_{IN+}$ et $V_{IN-}$ appliquées aux bornes de grille des transistors N1 et N2 peuvent définir des signaux de données en bande de base à 25 kHz. Par contre, les tensions alternatives appliquées aux bornes LO+ et LO- peuvent définir des signaux de forme sinusoïdale ayant une fréquence de l'ordre de 48 MHz ou 96 MHz par exemple. Avec ce mélange de signaux de fréquences différentes, la tension de sortie $V_{OUT}$ comprend des signaux de données à fréquence intermédiaire de l'ordre de 48 MHz ou 96 MHz.

Le bloc de polarisation 3 de ce mélangeur comprend encore un second miroir de courant. Ce second miroir de courant est composé de trois transistors PMOS P3, P4 et P5 dont la borne de source est reliée à la seconde borne d'alimentation $V_{DD}$ du circuit. Le premier transistor PMOS P3 du second miroir est monté en diode avec une borne de grille reliée à une borne de drain pour recevoir un courant d'un troisième transistor NMOS N6 à travers un second transistor intermédiaire NMOS N14. Le transistor N6 a donc sa borne de source reliée à la première borne d'alimentation $V_{SS}$, et sa borne de grille reliée à la borne de grille des transistors N3, N4 et N5. La borne de drain du transistor N6 est reliée à la borne de source du second transistor intermédiaire NMOS N14, qui a sa borne de grille reliée à la borne de grille du transistor N13 et sa borne de drain reliée à la borne de drain du transistor PMOS P3.

Les second et troisième transistors PMOS P4 et P5 du second miroir ont une borne de grille reliée à la borne de grille du premier transistor PMOS P3. Les transistors P4 et P5 fournissent, chacun, un courant constant d'atténuation du courant de charge respectivement à la borne de drain des premier et second transistors de commande N11 et N12 du bloc transconducteur 2. De cette manière, il est possible d'atténuer le courant de charge fourni à chaque résistance de charge $R_L$ et $R_{L'}$.

A partir de la description qui vient d'être faite, de multiples variantes de réalisation du circuit d'asservissement de la transconductance d'au moins un transistor peuvent être conçues par l'homme du métier sans sortir du cadre de l'invention définie par les revendications. La configuration du circuit d'asservissement pourrait être réalisée, inversement, en remplaçant les transistors PMOS par des transistors NMOS et les transistors NMOS par des transistors PMOS et en plaçant chaque résistance de charge du côté de la première borne d'alimentation du circuit. Il pourrait être imaginé, également, de remplacer chaque transistor MOS par des transistors bipolaires.

## Revendications

1. Circuit (1) d'asservissement de la transconductance d'au moins un transistor (N1, N2) en conduction, le circuit comprenant :

   - un bloc transconducteur (2) qui comprend le transistor en conduction muni d'une borne de commande et de deux bornes de courant,
   - un bloc de polarisation (3) pour polariser le bloc transconducteur,
   - un bloc de charge ($R_L$, $R_{L'}$) recevant un courant de charge fourni par le bloc transconducteur,
     le circuit étant **caractérisé en ce que** le bloc de polarisation comprend une résistance de référence ($R_0$) et **en ce que** le bloc de polarisation fournit au bloc transconducteur au moins un signal de polarisation dépendant de la résistance de référence de manière à ajuster la tension entre les deux bornes de courant du transistor en conduction de sorte que la valeur de la transconductance du transistor en conduction est inversement proportionnelle à la valeur de la résistance de référence.

2. Circuit d'asservissement (1) selon la revendication 1, **caractérisé en ce que** le bloc transconducteur (2) comprend au moins un transistor de commande (N11, N12) relié au transistor en conduction, une borne de commande du transistor de commande recevant le signal de polarisation du bloc de polarisation pour permettre au transistor de commande d'ajuster la tension entre les bornes de courant du transistor en conduction.

3. Circuit d'asservissement (1) selon la revendication 2, le circuit étant alimenté en tension par une source de tension continue par des première et seconde bornes d'alimentation ($V_{SS}$, $V_{DD}$), **caractérisé en ce que** le transistor de commande (N11, N12) et le transistor en conduction (N1, N2) sont des transistors MOS d'un même type de conductivité P ou N, qui sont reliés en série dans un montage cascode, **en ce que** le transistor en conduction comprend une borne de source reliée à une première borne d'alimentation ($V_{SS}$) du circuit et une borne de drain reliée à une borne de source du transistor de commande et **en ce que** le signal de polarisation est appliqué sur la borne de grille du transistor de commande sous forme d'une tension de grille dépendant de la résistance de référence ($R_0$) pour ajuster la tension entre la source et le drain du transistor en conduction.

4. Circuit d'asservissement (1) selon l'une des revendications précédentes, le circuit étant réalisé avec des transistors MOS d'un premier type de conductivité P ou N ou d'un second type de conductivité N ou P, **caractérisé en ce que** le bloc de polarisation (3) comprend un premier miroir de courant qui est composé de deux transistors MOS (P1, P2) d'un premier type de conductivité dont une borne de source des transistors MOS est reliée à une seconde borne d'alimentation ($V_{DD}$) du circuit, le premier transistor MOS (P1) du premier miroir étant monté en diode avec une borne de grille reliée à une borne de drain et le second transistor MOS (P2) du premier miroir ayant une borne de grille reliée à la borne de grille du premier transistor MOS, **en ce que** le bloc de polarisation comprend au moins deux transistors (N3, N4) d'un second type de conductivité, dont une borne de source des transistors MOS est reliée à une première borne d'alimentation ($V_{SS}$) du circuit, une borne de grille du premier transistor MOS (N3) du second type étant reliée à une borne de grille du second transistor MOS (N4) du second type afin d'être polarisée par une tension continue en mode commun ($V_{COM}$), **en ce qu'**un transistor MOS suiveur (N5) d'un second type de conductivité comprend une borne de grille reliée à la borne de grille des premier et second transistors MOS du second type et une borne de drain reliée à la borne de drain du premier transistor MOS du premier type monté en diode et **en ce que** la résistance de référence ($R_0$) est connectée entre une borne de source du transistor MOS suiveur et une borne de drain du second transistor MOS (N4) du second type.

5. Circuit d'asservissement (1) selon la revendication 4, **caractérisé en ce qu'**un transistor MOS intermédiaire (N13) monté en diode d'un second type de conductivité comprend une borne de drain reliée à une borne de drain du second transistor MOS (P2) du premier miroir et une borne de source connectée à une borne de drain du premier transistor MOS (N3) du second type, **en ce que** le second transistor MOS (P2) du premier miroir fournit un courant k fois plus fort que le premier transistor MOS (P1) du premier miroir, k étant un nombre entier plus grand que 1, et **en ce qu'**une borne de grille du transistor MOS intermédiaire est reliée à une borne de grille du transistor MOS de commande du second type.

6. Circuit d'asservissement (1) selon l'une des revendications 4 et 5, **caractérisé en ce que** le bloc transconducteur (2) comprend deux transistors MOS en conduction (N1, N2) du second type reliés respectivement à deux transistors MOS de commande (N11, N12) du second type dans un montage en cascode, la borne de source des deux transistors en conduction étant connectée à une première borne d'alimentation du circuit et la borne de grille des deux transistors de commande étant reliée à la borne de grille du transistor MOS intermédiaire (N13) du bloc de polarisation (3) pour que la tension entre la source et le drain de chaque transistor en conduction soit ajustée par une tension de grille appliquée sur la borne de grille du transistor MOS intermédiaire de sorte que la valeur de la transconductance de chaque transistor en conduction est inversement proportionnelle à la valeur de la résistance de référence.

7. Circuit d'asservissement (1) selon la revendication 6, le circuit formant un mélangeur de signaux alternatifs, **caractérisé en ce que** le bloc transconducteur (2) comprend deux paires différentielles de transistors MOS (N15, N16, N17, N18) du second type, une borne de source des transistors MOS de la première paire (N15, N16) étant reliée à la borne de drain du premier transistor de commande (N11) pour recevoir un premier courant alternatif fourni par le premier transistor en conduction (N1) et une borne de source des transistors MOS de la seconde paire (N17, N18) étant reliée à la borne de drain du second transistor de commande (N12) pour recevoir un second courant alternatif inverse déphasé de 180° par rapport au premier courant alternatif, fourni par le second transistor en conduction (N2), **en ce que** le bloc de charge comprend une première résistance ($R_L$), qui est connectée entre une seconde borne d'alimentation ($V_{DD}$) du circuit et une borne de drain du premier transistor de la première paire (N15) et du second transistor de la seconde paire (N17) et une seconde résistance ($R_{L'}$), qui est connectée entre la seconde borne d'alimentation du circuit et une borne de drain du second transistor de la première paire (N16) et du premier transistor de la seconde paire (N18), **en ce que** la borne de grille (LO+) des premiers transistors des première et seconde paires est commandée par une première tension alternative d'une première source de tension et **en ce que** la borne de grille (LO-) des seconds transistors des première et seconde paires est commandée par une seconde tension alternative d'une seconde source de tension déphasée de 180° par rapport à la première tension alternative pour délivrer aux bornes des résistances de charge une tension de sortie alternative ($V_{OUT}$) de fréquence dépendant de la fréquence des premier et second courants de charge et de la fréquence des première et seconde tensions alternatives.

**8.** Circuit d'asservissement (1) selon la revendication 7, **caractérisé en ce que** le bloc de polarisation (3) comprend un second miroir de courant qui est composé de trois transistors MOS (P3, P4, P5) d'un premier type de conductivité dont une borne de source des transistors est reliée à la seconde borne d'alimentation ($V_{DD}$) du circuit, le premier transistor MOS (P3) du second miroir étant monté en diode avec une borne de grille reliée à une borne de drain pour recevoir un courant équivalent au courant du premier transistor (N3, N6) du second type, et **en ce que** les second et troisième transistors MOS du second miroir ont une borne de grille reliée à la borne de grille du premier transistor MOS du second miroir pour fournir, chacun, un courant d'atténuation respectivement à la borne de drain des premier et second transistors de commande (N11, N12) du bloc transconducteur pour atténuer le courant de charge fourni à chaque résistance de charge ($R_L$, $R_L$').

Fig. 1

Fig. 2

Fig. 3

EP 1 589 657 A1

**Office européen des brevets**

## RAPPORT DE RECHERCHE EUROPEENNE

Numéro de la demande

EP 04 10 1609

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 0 397 015 A (NAT SEMICONDUCTOR CORP) 14 novembre 1990 (1990-11-14) | 1,2 | H03F1/30 H03F1/22 H03F3/45 |
| Y | * page 2, ligne 42 - page 4, ligne 42; figure 1 * ----- | 3-8 | |
| Y | US 5 644 269 A (WONG SHYH-CHYI ET AL) 1 juillet 1997 (1997-07-01) * colonne 5, ligne 15 - colonne 6, ligne 19; figures 4,6 * ----- | 3-8 | |
| X | US 4 388 539 A (BOEKE WOUTER M) 14 juin 1983 (1983-06-14) * colonne 3, ligne 39 - colonne 4, ligne 10; figure 2 * ----- | 1,2 | |
| X | US 2003/227329 A1 (GRASSET JEAN-CHARLES ET AL) 11 décembre 2003 (2003-12-11) * alinéas [0131] - [0137]; figure 5 * ----- | 1 | |
| A | US 6 104 249 A (CALLAHAN JR MICHAEL J) 15 août 2000 (2000-08-15) * le document en entier * ----- | 1-8 | |

DOMAINES TECHNIQUES RECHERCHES (Int.Cl.7)

H03F

Le présent rapport a été établi pour toutes les revendications

| Lieu de la recherche | Date d'achèvement de la recherche | Examinateur |
|---|---|---|
| La Haye | 1 septembre 2004 | Fedi, G |

EPO FORM 1503 03.82 (P04C02)

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
...................................................................................
& : membre de la même famille, document correspondant

**ANNEXE AU RAPPORT DE RECHERCHE EUROPEENNE
RELATIF A LA DEMANDE DE BREVET EUROPEEN NO.**

EP 04 10 1609

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-09-2004

| Document brevet cité au rapport de recherche | | Date de publication | Membre(s) de la famille de brevet(s) | | Date de publication |
|---|---|---|---|---|---|
| EP 0397015 | A | 14-11-1990 | US | 5021682 A | 04-06-1991 |
| | | | DE | 69029424 D1 | 30-01-1997 |
| | | | DE | 69029424 T2 | 10-07-1997 |
| | | | EP | 0397015 A2 | 14-11-1990 |
| | | | JP | 3003509 A | 09-01-1991 |
| | | | KR | 164657 B1 | 20-03-1999 |
| US 5644269 | A | 01-07-1997 | AUCUN | | |
| US 4388539 | A | 14-06-1983 | NL | 8001115 A | 16-09-1981 |
| | | | AU | 539887 B2 | 18-10-1984 |
| | | | AU | 6757781 A | 03-09-1981 |
| | | | BE | 887643 A1 | 24-08-1981 |
| | | | CA | 1165826 A1 | 17-04-1984 |
| | | | DE | 3106558 A1 | 07-01-1982 |
| | | | FR | 2476940 A1 | 28-08-1981 |
| | | | GB | 2070360 A ,B | 03-09-1981 |
| | | | HK | 75584 A | 12-10-1984 |
| | | | JP | 1004364 B | 25-01-1989 |
| | | | JP | 1526010 C | 30-10-1989 |
| | | | JP | 56168298 A | 24-12-1981 |
| | | | SE | 450676 B | 13-07-1987 |
| | | | SE | 8101161 A | 26-08-1981 |
| US 2003227329 | A1 | 11-12-2003 | FR | 2834088 A1 | 27-06-2003 |
| | | | GB | 2384125 A ,B | 16-07-2003 |
| US 6104249 | A | 15-08-2000 | AUCUN | | |

EPO FORM P0460

Pour tout renseignement concernant cette annexe : voir Journal Officiel de l'Office européen des brevets, No.12/82